Europäisches Patentamt

European Patent Office

Office européen des brevets

(11) Numéro de publication: **0 209 432**
**A1**

## (12) DEMANDE DE BREVET EUROPEEN

(21) Numéro de dépôt: 86401387.5

(22) Date de dépôt: 24.06.86

(51) Int. Cl.⁴: **H01J 37/28 , G01R 31/28**

(30) Priorité: 28.06.85 FR 8509893

(43) Date de publication de la demande:
**21.01.87 Bulletin 87/04**

(84) Etats contractants désignés:
**DE GB NL**

(71) Demandeur: **CAMECA**
**103, Boulevard Saint-Denis**
**F-92400 Courbevoie(FR)**

(72) Inventeur: **Costa de Beauregard, François**
**THOMSON-CSF SCPI 19, avenue de Messine**
**F-75008 Paris(FR)**
Inventeur: **Rouberol, Jean-Michel**
**THOMSON-CSF SCPI 19, avenue de Messine**
**F-75008 Paris(FR)**

(74) Mandataire: **Lincot, Georges et al**
**THOMSON-CSF SCPI 19, avenue de Messine**
**F-75008 Paris(FR)**

(54) **Testeur de circuit intégré à faisceau d'électrons.**

(57) Le testeur comprend une source d'électrons primaires (17), des moyens de support (16) du circuit intégré, une colonne électronique (17, ... , 30) fixée au-dessus des moyens de support du circuit intégré pour focaliser le faisceau d'électrons primaires émis à la surface du circuit intégré sur les points du circuit à tester. Il comprend également des moyens (27, 28, 29, 30) pour accélérer les électrons secondaires émis du circuit intégré dans une direction colinéaire et opposée à celle du faisceau d'électrons primaires et des moyens de séparation (24) pour diriger hors de la colonne le faisceau d'électrons secondaires accélérés par les moyens d'accélération et un spectromètre d'énergie (32) couplé aux moyens de séparation (24) et fixé à l'extérieur de la colonne pour analyser selon leur énergie les électrons du faisceau d'électrons secondaires émis séparés par les moyens de séparation (24).

FIG_4

## Testeur de circuit intégré à faisceau d'électrons

La présente invention concerne un testeur de circuits intégrés à faisceau d'électrons.

Il est connu, pour tester les circuits intégrés, d'utiliser des appareils de test dérivés des microscopes électroniques à balayage.

Généralement, dans ces appareils, un faisceau d'électrons primaires est finement focalisé sur chaque point à tester du circuit intégré et le potentiel électrique y est déterminé en mesurant dans une région à un certain potentiel l'énergie des électrons secondaires engendrés par le bombardement du faisceau primaire.

Des exemples de réalisation de testeurs fonctionnant suivant ce principe sont décrits dans les articles intitulés

-"Electron Beam Testing of VLSI circuits" ayant pour auteurs Eckard Wolfgang et al et publié dans la revue IEEE Journal of solid state circuits, vol. sc 14 n°2 avril 1979.

et "Fundamentals of electron beam testing of integrated circuits" ayant pour auteurs E. Menzel et E. Kubalek et publié dans la revue SCANNING vol.5, 103.122 (1983).

Dans ces testeurs, l'espace entre le circuit à tester et la pièce polaire appartenant à la dernière lentille de focalisation et lui faisant face est occupé par le spectromètre d'électrons secondaires.

Or les qualités d'un spectromètre, luminosité et pouvoir de résolution, sont d'autant plus grandes que les dimensions le sont.

Mais en revanche, les qualités de la lentille sont d'autant plus faibles (ses aberrations plus élevées) que sa distance focale est grande.

On est donc amené, dans la conception des testeurs de type connu, à faire un compromis entre les dimensions du spectromètre et la distance focale de la dernière lentille.

En outre, le fait de placer le spectromètre entre lentille et circuit intégré devient gênant si on veut placer également dans cet intervalle des dispositifs accessoires tels que, notamment, des pointes d'alimentation pour tester des circuits intégrés sur plaquette, avant découpage.

Le but de l'invention est de pallier les inconvénients précités.

A cet effet, l'invention a pour objet un testeur de circuit intégré à faisceau d'électrons comprenant une source d'électrons primaires, des moyens de support du circuit intégré, une colonne électronique fixée vis-à-vis des moyens de support du circuit intégré pour focaliser sur les points à tester du circuit le faisceau d'électrons primaires, caractérisé en ce qu'il comprend des moyens pour accélérer les électrons secondaires émis par le circuit intégré dans une direction colinéaire et de sens opposé à celle du faisceau d'électrons primaires et des moyens de séparation pour diriger hors de la colonne le faisceau d'électrons secondaires accélérés par les moyens d'accélération et un spectromètre d'énergie couplé aux moyens de séparation et fixé à l'extérieur de la colonne pour analyser selon leur énergie les électrons du faisceau d'électrons secondaires émis, séparés par les moyens de séparation.

L'invention a pour avantage qu'elle laisse libre l'espace compris entre la pièce polaire finale de la dernière lentille de la colonne électronique et le circuit à tester ce qui permet de réduire la distance focale de cette dernière lentille et par conséquent de réduire également ses aberrations.

La suppression du spectromètre dans ledit espace permet également d'en disposer plus facilement pour l'installation, par exemple, de pointes d'alimentation pour le test de circuits intégrés sur plaquettes avant leur découpage.

Comme le faisceau d'électrons secondaires est dirigé hors de la colonne par les moyens de séparation, il n'existe pratiquement pas de contrainte d'environnement pour la conception du spectromètre qui est à fixer à l'extérieur de la colonne. En particulier ses dimensions peuvent être augmentées considérablement par rapport à celles des spectromètres des testeurs de type connu ce qui représente un avantage important du point de vue de la qualité des résultats obtenus, à la fois sur le plan de la luminosité et sur celui de la résolution spectrale.

L'invention a également pour avantage qu'elle permet de corriger la déviation du faisceau secondaire corrélativement à celle du faisceau primaire de façon à obtenir un faisceau secondaire dans une position fixe relativement à l'entrée du spectromètre quels que soient, au moins dans une certaine mesure, les déplacements du point d'émission sur le circuit intégré.

Ceci permet de garantir des caractéristiques de sensibilité et de précision constantes sur une surface relativement étendue du circuit intégré pouvant s'étendre, par exemple, jusqu'à des surfaces voisines d'un carré de 500 microns de côté.

D'autre part, le passage d'un point de test à un autre est facilité et peut être obtenu par de simples déviations du faisceau primaire d'électrons, ce qui constitue à la fois un procédé plus précis et plus rapide que le procédé mécanique de déplacement

de l'objet qu'il faut mettre en oeuvre dans les testeurs de l'art antérieur précités si on veut conserver au spectromètre rigoureusement les mêmes caractéristiques d'un point de mesure à l'autre.

D'autres caractéristiques et avantages de l'invention apparaîtront également à l'aide de la description qui va suivre, faite en regard des dessins annexés qui représentent :

-la figure 1 une réalisation sous forme - schématique d'un testeur de circuit intégré à faisceau d'électrons de l'art antérieur ;

-la figure 2A le spectre en énergie des électrons secondaires obtenus à l'aide du testeur de la figure 1 ;

-la figure 2B le signal correspondant au spectre de la figure 2A, fourni par un spectromètre à contre-champ ;

-les figures 3A, 3B et 3C des graphes de temps illustrant une utilisation du testeur de la figure 1 en mode stroboscopique ;

-la figure 4 un mode de réalisation sous forme schématique d'un testeur suivant l'invention ;

-la figure 5 un schéma optique de la partie supérieure du testeur ;

-la figure 6 un schéma optique du séparateur de faisceaux ;

-la figure 7 un schéma optique du dispositif de collection des électrons secondaires ;

-la figure 8 un schéma optique de la partie inférieure du testeur ;

-les figures 9A et 9B les trajectoires d'électrons primaires et secondaires au travers du système de balayage du testeur suivant l'invention ;

-les figures 10 et 11 un mode de réalisation du testeur de circuits intégrés suivant l'invention ;

-les figures 12A et 12B les aimants constituant le séparateur schématisé figure 6.

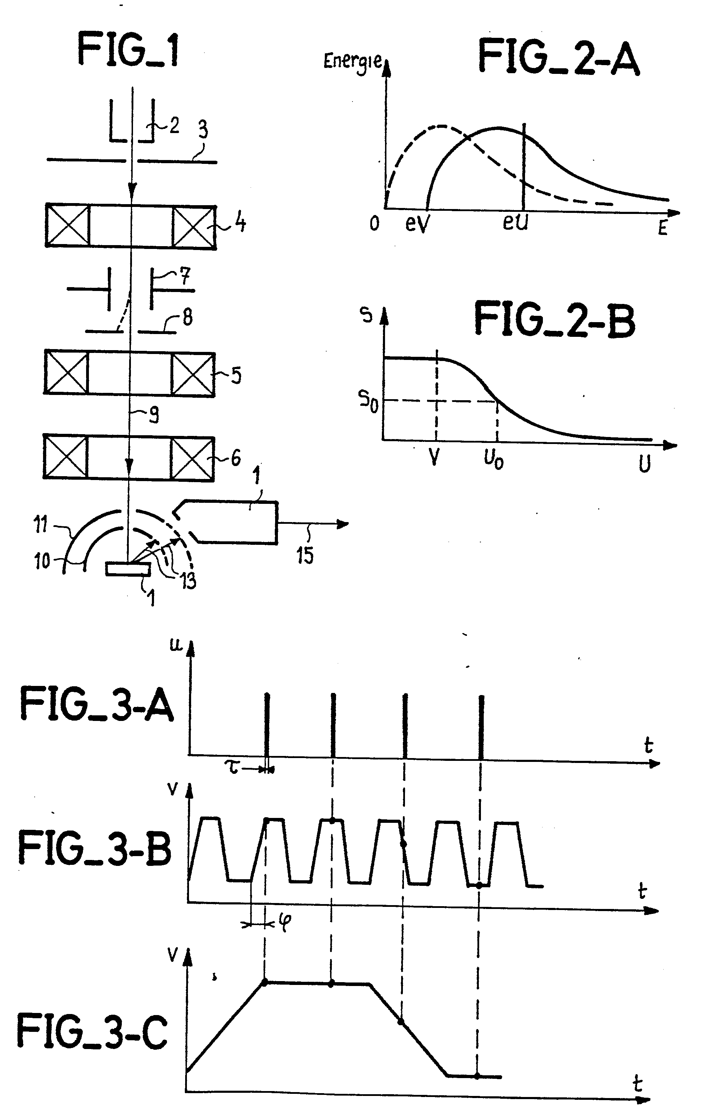

La figure 1 représente très schématiquement la partie physique d'un testeur de circuit intégré de l'art connu. Selon cette réalisation le circuit intégré 1 est placé dans une enceinte non représentée et il est relié à un dispositif d'alimentation extérieur, également non représenté, dont la masse est réunie à celle de l'appareil, prise comme référence des potentiels.

Une colonne électronique communiquant avec la susdite enceinte est disposée perpendiculairement à la surface du circuit intégré. Cette colonne comprend typiquement un canon à électrons constitué d'un ensemble cathode-wehnelt 2 et d'une anode 3, des lentilles électromagnétiques 4, 5 et 6, un déviateur électrostatique 7, associé à un diaphragme 8 ; l'ensemble de ces éléments étant centré par rapport à un axe optique 9.

Le canon à électrons émet un faisceau d'électrons primaires qui est focalisé par les lentilles électromagnétiques 4, 5 et 6 de façon à former un spot de diamètre très réduit sur le point à tester du circuit intégré.

Le déviateur 7 permet, en amenant le faisceau hors du trou du diaphragme 8 d'effectuer une modulation du faisceau par tout ou rien.

Le bombardement du point à tester par les électrons du faisceau primaire fait apparaître une émission d'électrons secondaires 13 qui sont détectés par un détecteur 14 constitué d'un scintillateur couplé à un photomultiplicateur.

Dans ces conditions, le spectre en énergie des électrons secondaires qui est mesuré et dont une représentation est montrée à la figure 2A, correspond au spectre d'émission des électrons secondaires décalé d'une quantité -eV où V est le potentiel du circuit intégré au point bombardé.

L'ensemble des grilles accélératrice et retardatrice 10 et 11, et le détecteur 14, constitue un spectromètre d'électrons secondaires, la grille accélératrice 10 du spectromètre ayant pour rôle de favoriser la collection des électrons secondaires. La grille retardatrice est polarisée à un potentiel -U par rapport à la masse et ne laisse passer que les électrons d'énergie supérieure à eU. En faisant varier U et en supposant fixe le potentiel V du point à tester le détecteur 14 fournit un signal S, représenté figure 2B, qui est l'intégrale du spectre.

La mesure du potentiel V du point à tester peut, de cette façon, être obtenue en mesurant la valeur du potentiel U pour laquelle le signal S atteint une fraction déterminée So de sa valeur maximale.

Le dispositif représenté à la figure 1 permet également d'effectuer des mesures dynamiques des signaux en différents points du circuit testé.

Cependant, ces mesures ne peuvent être faites en temps réel que jusqu'à des fréquences ne dépassant pas en pratique quelques mégahertz. Pour aller au-delà, les systèmes connus mettent en oeuvre un procédé d'échantillonnage ou de stroboscopie consistant à déclencher le faisceau d'électrons primaires durant de très brèves impulsions de durée $\tau$, en synchronisme avec le signal étudié et avec un certain décalage de phase $\rho$ par rapport à celui-ci.

De la façon représentée aux figures 3A à 3C, l'intégration du signal correspondant aux électrons secondaires pendant un certain nombre de périodes, donne la valeur instantanée du signal - (figures 3B et 3C), à la phase $\rho$, avec une résolution temporelle de l'ordre de $\tau$.

Par un balayage de la phase $\rho$, il est possible de relever le signal, étalé dans le temps.

Le testeur qui vient d'être décrit présente les inconvénients déjà signalés dûs pour une grande part à l'interposition des grilles 10, 11 et du détecteur d'électrons 14 dans l'espace compris entre le circuit intégré 1 et la dernière lentille 6 de la colonne électronique.

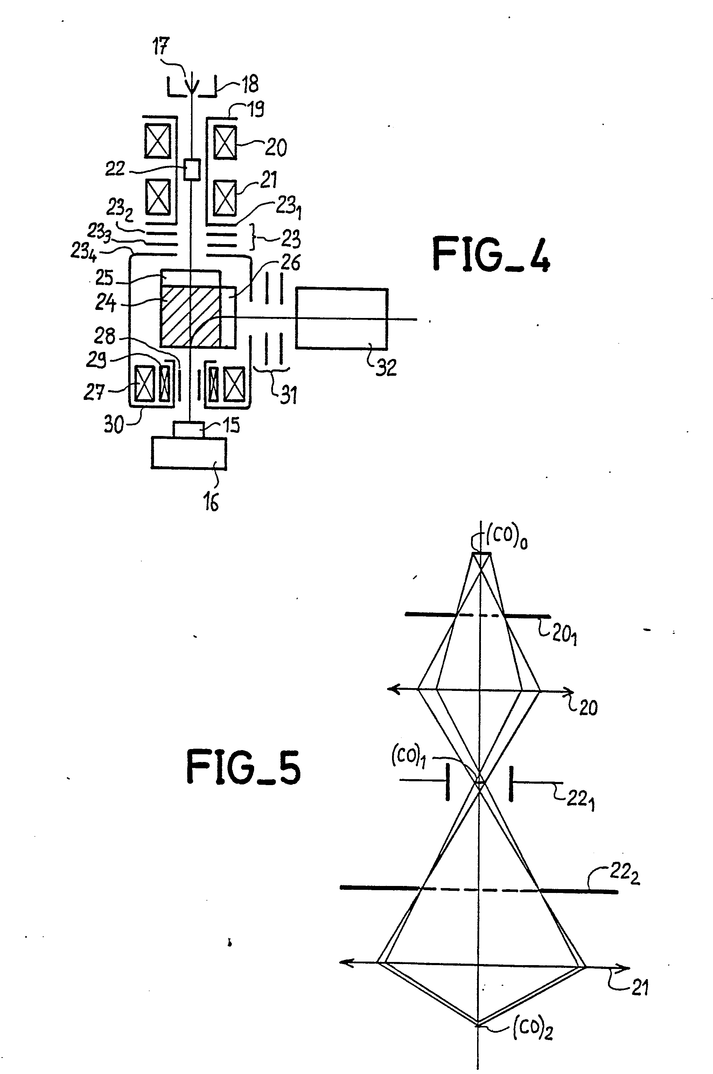

Le testeur de circuit intégré à faisceaux d'électrons suivant l'invention qui permet de remédier à ces inconvénients, est décrit ci-après à l'aide du schéma simplifié de la figure 4.

La partie physique du testeur que représente cette figure comprend trois parties principales :

-un dispositif de déplacement 16 d'un circuit intégré 15

-une colonne électronique composée des éléments 17 à 30

-un spectromètre d'électrons secondaires 32 muni d'une lentille de couplage 31.

Le circuit intégré 15 est alimenté par un dispositif, non représenté dont la masse est reliée à celle de l'appareil.

La colonne électronique comprend :

-un canon à électrons constitué d'une cathode 17, d'un wehnelt 18 et d'une anode 19,

-deux lentilles électromagnétiques ou condenseurs 20 et 21,

-un dispositif d'échantillonnage du faisceau 22 situé entre les lentilles 20 et 21,

-une lentille électrostatique 23 comprenant 4 électrodes $23_1$ à $23_4$,

-un séparateur magnétique 24 associé à un double quadrupôle d'entrée 25 et à un quadrupôle de sortie 26,

-une lentille magnétique finale 27,

-un dispositif de balayage placé dans le canal de la lentille 27 et, constitué d'un déviateur électrostatique 28 et d'un déviateur électromagnétique 29 coaxiaux,

-une anode 30 d'accélération des électrons secondaires.

Le spectromètre 32 fixé au flanc de la colonne, est couplé à celle-ci par une lentille électrostatique 31 dont le rôle est, en particulier, d'amener les électrons à avoir, à l'entrée du spectromètre, une énergie convenable. Par exemple, avec un spectromètre à grille (ou encore dit "à contre-champ") on ramènera les électrons à une énergie voisine de celle d'émission. Avec un spectromètre à dispersion, on leur gardera une énergie de l'ordre du keV.

Les potentiels des différentes parties de la colonne sont fixés de la façon suivante :

-la cathode 17 du canon à électrons est à un potentiel -E correspondant à l'énergie eE (au potentiel du circuit intégré 15 près) avec laquelle on veut que les électrons frappent le circuit intégré, cette énergie est en pratique comprise entre 0,5 keV et 10 keV,

-l'anode 19 du canon est à la masse et le tube intérieur aux lentilles 20 et 21 reliant l'anode 19 à l'électrode 23 est également à la masse pour des raisons de commodité,

-l'anode annulaire 30 d'accélération des électrons secondaires est polarisée de façon à créer à la surface du circuit intégré un champ de l'ordre de 1 kV/mm, et à collecter ces électrons avec une bonne efficacité; en pratique, elle est par exemple à 8 kV et distante de 7 mm de l'échantillon.

D'autre part, pour que le produit de la valeur du rayon de giration des électrons secondaires dans le séparateur 24 par la valeur de l'induction ne soit pas trop faible, ces électrons doivent y avoir une énergie suffisante. On a trouvé commode de leur donner une énergie égale à leur énergie d'émission augmentée de eV en mettant le séparateur 24 au potentiel de l'anode 30.

Le séparateur est contenu dans une enceinte équipotentielle dont l'anode 30 constitue le fond et l'électrode $23_4$ la partie supérieure.

Enfin, en ce qui concerne la lentille 23, il découle de ce qui précède que ses électrodes extrêmes $23_1$ et $23_4$ sont respectivement à la masse et à V.

Ses électrodes internes $23_2$ et $23_3$ sont polarisées en fonction de l'énergie des électrons primaires pour donner à la lentille la distance focale propre à réaliser une conjugaison optique qui sera précisée plus loin.

Le schéma optique détaillé de la partie supérieure de la colonne électronique est représenté à la figure 5.

Cette partie comprend, le canon à électrons, non représenté, un diaphragme d'ouverture $20_1$, le premier condenseur 20, le second condenseur 21, le dispositif d'échantillonnage du faisceau constitué par un déviateur électrostatique $22_1$ et un diaphragme d'occultation $22_2$.

Dans cette partie de la colonne, le "cross over" ou pupille du canon $(C0)_0$ est réduit successivement en $(C0)_1$ puis en $(C0)_2$.

Le lentille 20 est réglée de façon à former l'image (C0), au niveau du déviateur 22₁.

De cette façon, l'image finale du "cross-over" sur le circuit intégré disparaît sur place quand on excite le déviateur 22₁.

D'autre part, le diaphragme d'occultation 22₂ est placé dans le plan conjugué, par rapport à la lentille 20, du diaphragme d'ouverture 20₁; de cette façon on obtient une déviation angulaire minimale pour couper complètement le faisceau.

Le séparateur magnétique 24 et les correcteurs associés 25 et 26 ont pour rôle :

-d'être achromatique et stigmatique pour le faisceau primaire, dans la gamme d'énergie de e - $(E+V)$, c'est-à-dire pour les valeurs indiquées plus haut de 8,5 keV à 18 keV.

-de dévier hors de la colonne le faisceau secondaire en conservant le stigmatisme.

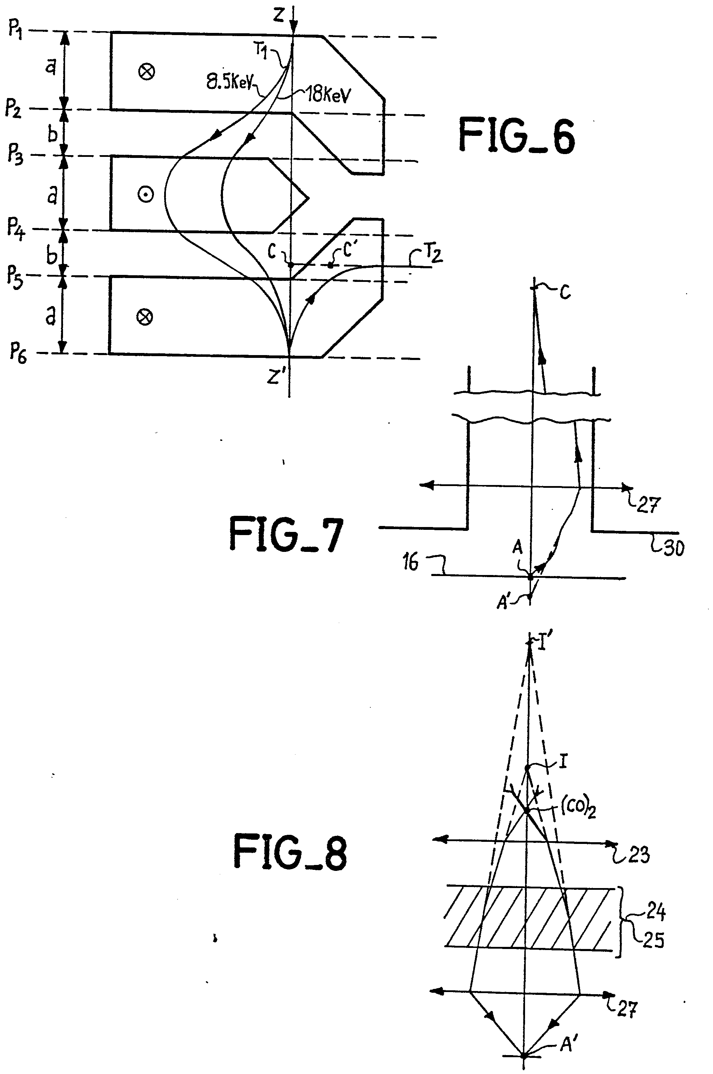

Le séparateur magnétique 24 dont un schéma théorique est montré à la figure 6 comprend essentiellement trois déviateurs magnétiques.

Il est équivalent pour le faisceau primaire à un ensemble de 3 champs magnétiques limités par des plans perpendiculaires à l'axe optique zz' définissant 3 volumes d'égales épaisseurs a et également écartés de b dans lesquels règnent des champs homogènes.

Entre P1 et P2 d'une part, et P5 et P6 d'autre part, le vecteur induction est normal au plan de la figure; il est orienté vers l'avant et a une intensité $B(z) = Bo$.

Entre P3 et P4 le vecteur induction est également normal au plan de la figure mais il est orienté vers l'arrière et a une intensité $B(z) = 2 Bo$.

En considérant la trajectoire d'un électron dans le plan de la figure il est possible de montrer que la condition, $\int B(z)dz = 0$ étant remplie, la trajectoire n'est pas déviée angulairement par ce triple déviateur.

En particulier, une trajectoire incidente suivant l'axe zz' ressortira du déviateur selon ce même axe.

Pour obtenir une zone de champ suffisamment étendue propre à effectuer convenablement la séparation du faisceau secondaire, pour également obtenir une symétrie favorable à la réalisation pratique des aimants créant ces champs, les 3 zones de champ magnétiques ont du côté de la déviation secondaire le contour montré sur la partie droite de la figure 6. Enfin sur cette figure, est indiqué la marche des rayons axiaux du faisceau primaire $T_1$ - (pour les valeurs extrêmes de $E+V$, c'est-à-dire 8,5 keV et 18 keV) et du faisceau secondaire $T_2$, d'énergie toujours égale à 10 keV, à l'énergie d'émission près.

Physiquement, les champs magnétiques à frontière brusque qui viennent d'être considérés ne peuvent pas exister; les champs magnétiques réels sont limités par des champs de fuite qui ont, sur les faisceaux une action de focalisation axiale - (c'est-à-dire perpendiculairement au plan de déviation du séparateur).

Le séparateur magnétique introduit donc sur le faisceau primaire de l'astigmatisme.

Pour corriger celui-ci, le double quadrupôle électrostatique 25 ayant le plan de déviation comme plan de symétrie est placé avant le séparateur.

Il est possible de montrer qu'il existe en effet un réglage de ce double quadrupôle pour lequel à un point objet donné correspond une image stigmatique.

Cette propriété est utilisée pour réaliser une conjugaison optique qui est expliquée plus loin à l'aide de la figure 8.

En ce qui concerne le faisceau secondaire, d'énergie voisine de 8 keV, l'induction dans le séparateur est réglée pour avoir une déviation de 90°.

Il est connu qu'un tel prisme (déviation de 90° et faces d'entrée et de sortie normales au faisceau) présente une focale chromatique au point C, intersection des prolongements des axes objet et image du prisme. Le point C est le point d'où semblent provenir des rayons coïncidant avec l'axe d'entrée mais correspondant à des particules d'énergies légèrement dispersées.

Comme il est également connu dans cette configuration que si le point objet est en C, son image en focalisation radiale coincide avec lui-même et que son image, en focalisation axiale sera en C', entre le point C et le point de sortie du prisme du rayon axial du faisceau, il est avantageux de régler la lentille finale 27 pour que l'image, en électrons secondaires, du point bombardé sur le circuit intégré se forme en C.

Le quadrupôle 26 qui est placé en sortie de prisme, amène le point C' en C qui constitue alors une image virtuelle achromatique et stigmatique du point bombardé sur le circuit intégré.

Ceci sera particulièrement avantageux si le spectromètre 32 est à dispersion et comporte un diaphragme d'entrée: on projetera sur ce dernier, au moyen de la lentille 31, la susdite image achromatique et stigmatique.

Le schéma de l'optique de collection des électrons secondaires est représenté figure 7.

Les électrons secondaires issus du point A sont accélérés par le champ électrique créé par l'anode 30 portée au potentiel V.

Ce dispositif constitue une optique à immersion et il est connu qu'une telle optique donne de A une image virtuelle A' située en arrière de la surface du circuit intégré, à une distance égale, à peu près, au tiers de la distance de l'anode au circuit intégré.

C'est ce point A' qui est imagé au moyen de la lentille magnétique 27 au point C, point achromatique objet du prisme magnétique de déviation des électrons secondaires.

La lentille 27 a donc une excitation fixe, indépendante de l'énergie des électrons primaires.

On notera d'autre part que les deux autres lentilles magnétiques du montage, 20 et 21, ont des réglages indépendants.

La lentille 20 est réglée pratiquement au voisinage de sa distance focale minimale pour obtenir le facteur de réduction maximal de la partie supérieure de la colonne.

La lentille 21 est réglée comme expliqué précédemment pour conjuguer le cross-over du canon $(CO)_o$ avec le plan moyen du déviateur $22_1$.

C'est donc la lentille électrostatique 23 qui est chargée de réaliser, dans toute la gamme d'énergie des électrons primaires, la conjugaison optique entre le cross-over $(CO)_o$ du canon et la surface du circuit intégré.

Pour cela, comme le montre le schéma de la figure 8, la lentille 23 est réglée pour donner du "cross-over" $(CO)_2$ une image centrée sur le point stigmatique objet I du séparateur magnétique qui correspond au point image I' coïncidant avec le conjugué de A' par rapport à la lentille 27.

La grande souplesse nécessaire à cette adaptation, de 0,5 keV à 10 keV d'énergie des électrons primaires, est obtenue en jouant sur la polarisation des deux électrodes internes.

Par exemple :

-pour 1 keV, l'électrode $23_2$ est à 4 kV et l'électrode $23_3$ à 8 keV ; la lentille 23 fonctionne en mode accélérateur.

-pour 10 keV, l'électrode $23_2$ est à la masse et l'électrode $23_3$ est à -4,5 kV ; la lentille 23 fonctionne alors dans des conditions proches de celles d'une lentille unipotentielle retardatrice.

Le tableau ci-dessous donne les caractéristiques optiques principales de la colonne pour les deux énergies, 1 keV et de 10 keV du faisceau primaire.

| ENERGIE PRIMAIRE | | 1 keV | 10 keV |
|---|---|---|---|
| GRANDISSEMENT | lentille 23 | 9 | 1,2 |
| | double quadrupôle + séparateur | 2,3 | 2,3 |
| | lentille 27 | 0,04 | 0,5 |
| FACTEUR DE REDUCTION DE L'ENSEMBLE 20,21 | | 120 | 200 |
| DIAMETRE DU SPOT SUR LE CIRCUIT INTEGRE (x) | | 0,3 $\mu$m | 0,3 $\mu$m |

(x) en supposant un diamètre de "cross-over" du canon de 40 $\mu$m.

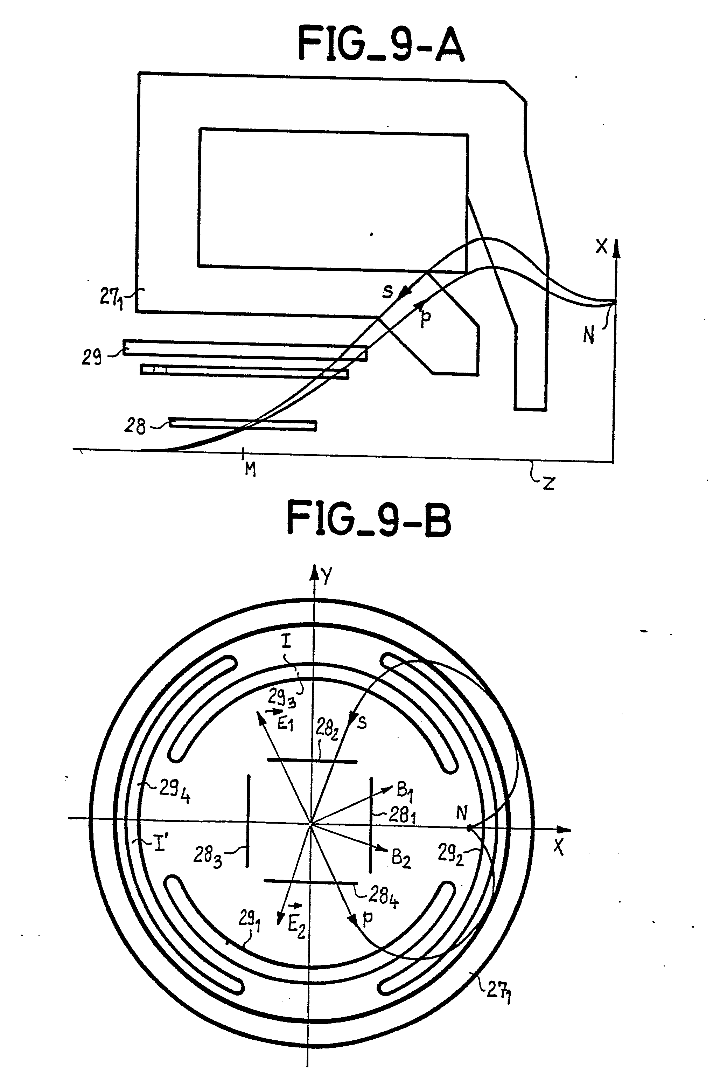

Des électrons secondaires émis normalement à la surface du circuit intégré et accélérés par l'anode 30 ont leur trajectoire qui est ramenée le long de l'axe optique Z de la manière qui est représentée aux figures 9A et 9B. Ces figures montrent respectivement des trajectoires très agrandies dans le sens des x, projetées dans un plan contenant l'axe Z et dans un plan orthogonal à celui-ci, relativement aux dispositifs de déflexion 28 et 29 et au circuit magnétique $27_1$ de la lentille 27.

Le déviateur électrostatique 28 est constitué de deux paires de plaques, $28_1$ et $28_3$ polarisées à $+V$ et $-V$ et $28_2$ et $28_4$, polarisées à $+V'$ et $-V'$. Ces deux paires de plaques dévient respectivement les électrons suivant les axes x et y.

Le déviateur électromagnétique 29 est constitué de deux paires de bobines $29_1$ et $29_3$, et $29_2$ et $29_4$, parcourues respectivement par les courants I et I' et déviant les électrons respectivement suivant les axes x et y.

Cette configuration permet en agissant sur les valeurs des courants I et I' et des tensions V et V' de diriger avec précision le faisceau d'électrons primaires sur n'importe quel point du circuit intégré, tout au moins pas trop éloigné de l'axe, et de ramener le faisceau d'électrons secondaires le long de l'axe optique Z.

Ces résultats sont obtenus en application des principes selon lesquels une particule de charge q et de vitesse $\vec{v}$ est soumise à une force $q\vec{E}$ dans un champ électrostatique $\vec{E}$ et à une force $q(\vec{v} \wedge \vec{B})$ dans un champ magnétique et du principe découlant des deux précédents selon lequel deux électrons de vitesses opposées subissent la même force dans un champ électrostatique et des forces opposées dans un champ magnétique.

En se reportant aux modes de représentation des figures 9A et 9B, un électron primaire d'énergie, par exemple, 1 keV arrivant le long de l'axe optique Z est dévié par le système de balayage en suivant la trajectoire indiquée p pour atteindre un point N du circuit intégré qui, dans le cas particulier de la figure 9B est situé sur l'axe des x, hors de l'axe optique Z. Naturellement à chaque point d'impact N sur le circuit intégré correspond des valeurs de courants I et I' ou de tensions V et V' particulières qui doivent également être déterminées en fonction de la rotation du faisceau dans la lentille 27 pour arriver sur chaque point d'impact.

En l'absence de déviation, un électron secondaire, d'énergie par exemple 5 eV qui serait émis au point N orthogonalement au circuit intégré, se dirigerait après avoir traversé le champ de la lentille sur le point M de l'axe optique représenté sur la figure 9A.

Dans ce mode de réalisation de la figure 9A le déviateur est centré sur le point M, et pour rendre très voisine la trajectoire des électrons secondaires de l'axe optique Z après la traversée du système de balayage, les bobines et les plaques de déflexion sont excitées respectivement par des courants $I_1$, $I'_1$ et des tensions $V_1$ et $V'_1$, de manière à obtenir deux vecteurs champ magnétique et électrique, respectivement $\vec{B_1}$ et $\vec{E_1}$ sur la figure 9B, en quadrature. Les champs $\vec{B_1}$ et $\vec{E_1}$ imposent à un

électron situé sur l'axe Z et dont la vitesse est colinéaire à cet axe deux forces de même direction. Si cet électron se dirige vers les Z croissants, comme c'est le cas par exemple d'un électron primaire, les deux forces sont de même sens. S'il se dirige par contre vers les Z décroissants comme c'est le cas d'un électron secondaire, les deux forces sont de sens contraires. Il suffit alors de choisir des valeurs de $I_1$, $I'_1$, $V_1$ et $V'_1$, telles que les champs $\vec{E_1}$ et $\vec{B_1}$ dévient très peu les électrons secondaires en déviant par contre de façon très importante les électrons primaires et de superposer respectivement à ces courants et ces tensions, des courants $I_2$ et $I'_2$ et des tensions $V_2$ et $V'_2$ pour obtenir des champs $\vec{E_2}$ et $\vec{B_2}$ représentés à la figure 9B en quadrature l'un par rapport à l'autre, vérifiant la relation $(\vec{B_2}, \vec{E_2}) = -\frac{\pi}{2}$ tels que les électrons primaires soient très peu déviés et qu'a contrario les électrons secondaires soient fortement déviés par le couple ($\vec{B_2}$, $\vec{E_2}$). Dans ces conditions un choix convenable des courants et des tensions de déviation permet de rapprocher la trajectoire des électrons secondaires de l'axe optique Z.

Ce procédé permet de rendre la position du faisceau secondaire à l'entrée du spectromètre indépendante du balayage primaire et d'éviter ainsi la "défocalisation" du spectromètre, phénomène qui serait particulièrement gênant si ce dernier est du type à dispersion.

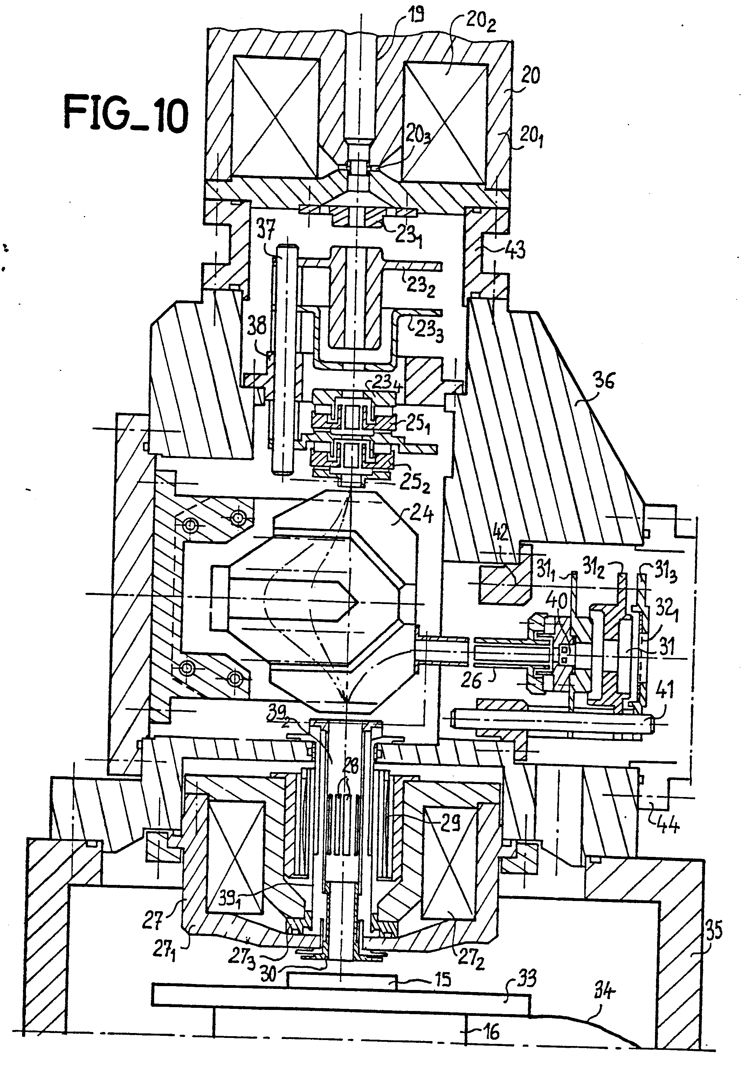

Un exemple de réalisation détaillé du testeur suivant l'invention est décrit ci-après à l'aide des figures 10, 11 et 12.

Sur la figure 10, le circuit intégré à tester 15 est fixé sur une platine 33 reliée à un générateur de signaux extérieur non représenté par des connexions électriques 34.

La platine 33 est elle-même portée par un dispositif mécanique 16 permettant de déplacer le circuit intégré dans son plan à l'aide de commandes extérieures non représentées, afin de placer sous le faisceau électronique le point ou la région à tester.

Le dispositif mécanique 16 est placé à l'intérieur d'une enceinte étanche 35 surmontée par la colonne électronique. Celle-ci est constituée du bâti 36 sur lequel et à l'intérieur duquel sont fixés les éléments 17 à 30 du testeur précédemment décrit à l'aide du schéma simplifié de la figure 4.

Le bâti 36 contient également la lentille 31 de couplage du spectromètre 32 et il supporte celui-ci.

Sur la figure 10 les éléments supérieurs de la colonne, 17, 18, 20 et 22 ne sont pas représentés non plus que le détecteur du spectromètre.

Les éléments représentés, relatifs à l'optique primaire, comprennent à partir du haut, la deuxième lentille électromagnétique 20, la lentille électrostatique 23, le double quadrupôle 25, le séparateur magnétique 24 et la dernière lentille électromagnétique 27.

-La deuxième lentille électro-magnétique 20 a une forme classique et est constituée du circuit magnétique $20_1$, de son bobinage d'excitation $20_2$ et de l'entretoise amagnétique $20_3$, le circuit magnétique $20_1$ est à la masse et la partie tubulaire de l'anode 19 de la figure 4 est, sur la figure 10, constituée par le canal du circuit magnétique $20_1$ lui-même.

-La lentille électrostatique 23 est constituée par quatre électrodes annulaires $23_1$ à $23_4$, l'électrode $23_1$ est fixée sur le circuit magnétique $20_1$ et est donc au potentiel de la masse, les électrodes $23_2$ et $23_3$ sont reliées indépendamment à 2 sources de tension variable extérieures, l'électrode finale $23_4$ est reliée au potentiel d'accélération des électrons secondaires V,

Le double quadrupôle 25 de correction d'astigmatisme du séparateur magnétique pour le faisceau primaire, est constitué des deux quadrupôles $25_1$ et $25_2$. Chacun de ceux-ci est constitué par deux paires de plaques, chacune disposée de telle façon que le plan de symétrie parallèle aux plaques soit respectivement dans le plan de la figure et perpendiculaire à celui-ci. Ces plaques sont portées à des potentiels de l'ordre de quelques centaines de volts par rapport à leur potentiel moyen, égal à V. Les électrodes de la lentille 23 et les quadrupôles $25_1$ et $25_2$ sont supportés par 4 colonnettes isolantes, dont une seule, la colonnette 37 est représentée. Ces colonnettes sont elles-mêmes fixées sur le bâti 36 par l'intermédiaire de la couronne 38.

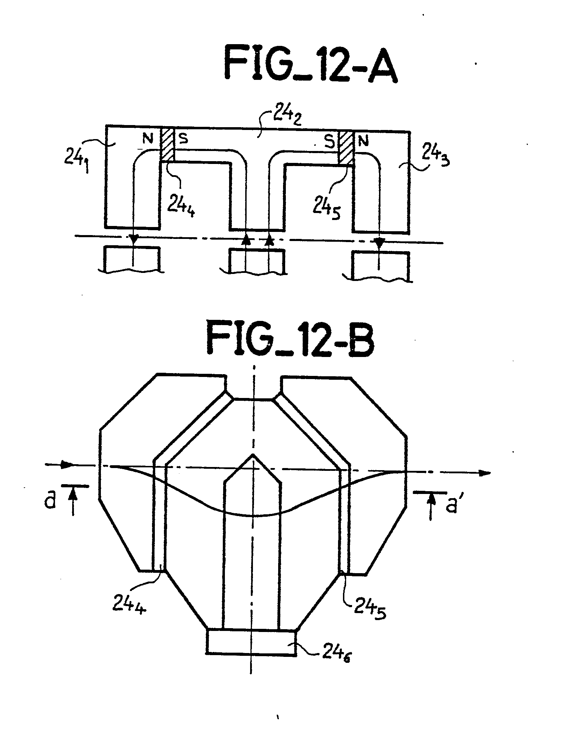

Le séparateur magnétique 24 a une structure qui sera expliquée plus loin au moyen des figures 12A et 12B.

La dernière lentille électro-magnétique 27, est constituée du circuit magnétique $27_1$, du bobinage d'excitation $27_2$ et de l'entretoise amagnétique $27_3$. La conception de cette lentille est semblable à celle de la dernière lentille d'un microscope électronique à balayage classique. Dans le canal de cette lentille sont disposés, coaxialement, et de l'extérieur vers l'intérieur :

-le déviateur électromagnétique 29

-un tube étanche $39_1$

-un tube conducteur $39_2$, porté au potentiel V et dont la partie inférieure, épanouie, constitue l'anode 30

-le déviateur électrostatique 28.

Toujours sur la figure 10, on trouve, situés latéralement par rapport à la colonne électronique, les éléments relatifs à l'optique des électrons secondaires constitués par le quadrupôle 26, la lentille électrostatique 31 et le diaphragme 40.

Le quadrupôle 26 de correction d'astigmatisme est constitué de deux paires de plaques, chacune disposée de telle façon que le plan de symétrie parallèle aux plaques soit respectivement dans le plan de la figure et perpendiculaire à celui-ci.

La lentille électrostatique 31 de couplage du spectromètre est constituée par les électrodes annulaires $31_1$, $31_2$ et $31_3$.

L'ouverture de l'électrode $31_3$ est recouverte par la grille $32_1$ du spectromètre 32 qui est du type à contre-champ.

Le diaphragme 40 limite l'ouverture du faisceau secondaire et élimine les électrons rétrodiffusés par la cible ou les parois. Les éléments 26, $31_1$, $31_2$, $31_3$ et 40 sont supportés par un montage à 4 colonnettes semblable à celui de la lentille 23, et dont une seule colonnette 41 est représentée.

Ces colonnettes sont elles-mêmes supportées par le bâti 35, par l'intermédiaire de la couronne 42.

Toujours sur la figure 10 on notera que les bobinages $20_2$ et $27_2$ ainsi que le déviateur 29 sont à la pression atmosphérique et que l'enceinte étanche à l'intérieur de laquelle on fait le vide est constituée, pour la partie basse de l'appareil représentée figure 10 par la chambre 35, le circuit magnétique $27_1$, l'entretoise $27_3$, le tube 38, le bâti 35, le circuit magnétique $20_1$, l'entretoise $20_3$, le tube intermédiaire 43, et le corps 44 du spectromètre.

L'étanchéité entre ces éléments est réalisée par des joints, en général non représentés.

Enfin on notera que dans l'exemple de réalisation représenté figure 10, les parois latérales de la boite équipotentielle 30 n'existent pas, mais que les éléments optiques qu'elle contient sont, chacuns, portés au potentiel V, et, suffisamment près les uns des autres pour que le faisceau primaire, entre l'électrode $23_4$ et l'anode 30, reste dans un espace équipotentiel au potentiel V.

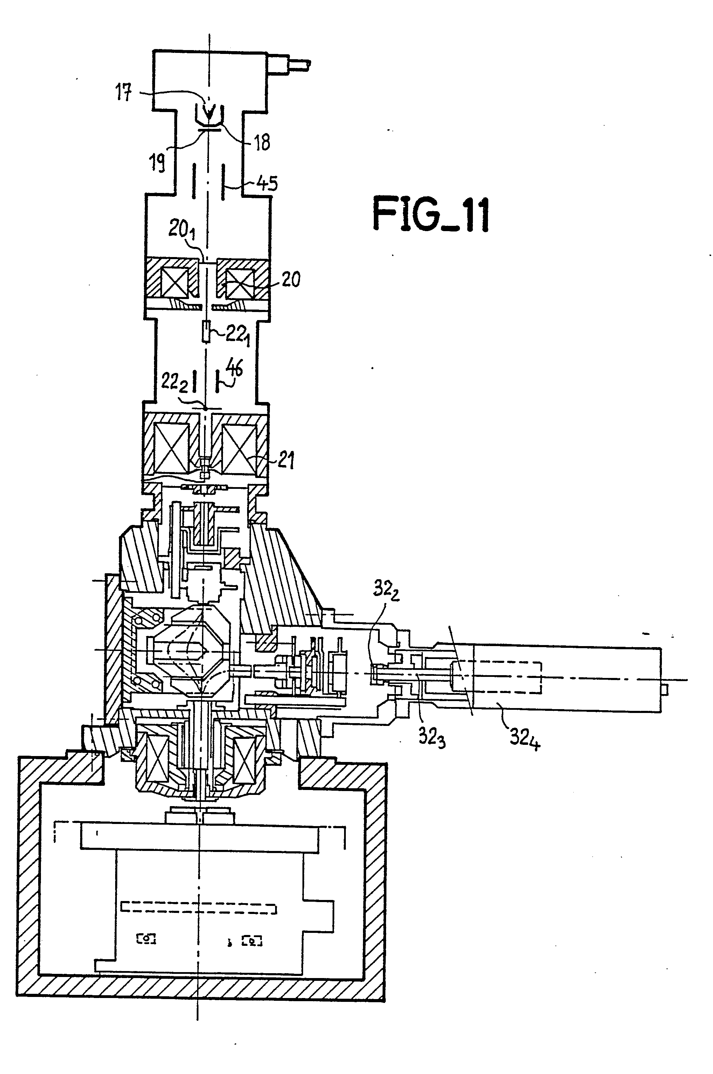

La figure 11 représente complètement l'exemple de réalisation de l'invention dont la figure 10 montrait la partie inférieure.

Par rapport à la figure 10, on y a représenté en plus les éléments connus de la technique constituant la partie supérieure de la colonne et le spectromètre qui sont :

-pour la colonne :

-le canon à électrons constitué de la cathode 17, le wehnelt 18, l'anode 19,

-le diaphragme d'ouverture 20,

-la première lentille électromagnétique 20,

-le déviateur 22, et le diaphragme $22_2$ constituant le modulateur par tout ou rien 22 du faisceau et

-les dispositifs d'alignement magnétiques 45 et 46,

- et pour le spectromètre :

-le scintillateur $32_2$

-le guide de lumière $32_3$

-et le photomultiplicateur $32_4$ .

Les figures 12A et 12B représentent le séparateur magnétique 24.

Ce séparateur est constitué de deux moitiés symétriques par rapport au plan de déviation (plan des figures 10 et 11).

La figure 12B représente une vue en plan d'une des moitiés suivant une direction perpendiculaire au plan de symétrie.

Cette moitié est constituée de 3 pièces polaires en fer doux $24_1$ , $24_2$ et $24_3$ et de deux aimants permanents $24_4$ et $24_5$ dont les pôles sont disposés de la façon indiquée afin de créer des champs de sens opposés dans l'entrefer central et dans les entrefers extrêmes.

Le shunt magnétique $24_6$ sert à régler l'achromatisme du séparateur.

La valeur de l'induction dans les entrefers extrêmes est de l'ordre de $10^{-2}$ Tesla, cette valeur étant la moitié de celle régnant dans l'entrefer central.

La figure 12A représente une vue en coupe suivant aa' du demi-déviateur représenté.

## Revendications

1. Testeur de circuit intégré (15) à faisceau d'électrons comprenant une source d'électrons primaires (17), des moyens de support (16) du circuit intégré, une colonne électronique (17, ..., 30) fixée au-dessus des moyens de support du circuit intégré pour focaliser le faisceau d'électrons primaires émis à la surface du circuit intégré sur les points du circuit à tester, caractérisé en ce qu'il comprend des moyens (27, 28, 29, 30) pour accélérer les électrons secondaires émis du circuit intégré dans une direction colinéaire et opposée à celle du faisceau d'électrons primaires et des moyens de séparation (24) pour diriger hors de la colonne le faisceau d'électrons secondaires accélérés par les moyens d'accélération et un spectromètre d'énergie (32) couplé aux moyens de séparation (24) et fixé à l'extérieur de la colonne pour analyser selon leur énergie les électrons du faisceau d'électrons secondaires émis séparés par les moyens de séparation (24).

2. Testeur de circuit intégré selon la revendication 1, caractérisé en ce que les moyens pour accélérer les électrons secondaires émis par le circuit intégré (15) dans une direction colinéaire et opposée à celle du faisceau d'électrons primaires sont placées directement en regard du circuit intégré et comprennent une anode d'accélération - (30) constituée par l'extrémité métallique d'un tube creux ($39_2$) pour laisser passer les électrons dans une direction colinéaire à l'axe du tube et une lentille électromagnétique (27) pour focaliser les électrons primaires du faisceau sur le circuit intégré (15).

3. Testeur de circuit intégré selon la revendication .1, caractérisé en ce que les moyens pour accélérer les électrons secondaires émis par le circuit intégré (15) dans une direction colinéaire et opposée à celle du faisceau d'électrons primaires sont placés directement en regard du circuit intégré et comprennent une lentille électromagnétique (27) pour focaliser les électrons primaires du faisceau sur le circuit intégré (15) et une anode d'accélération (30) supportée par l'extrémité métallique d'un tube creux fixé le long de l'axe optique de la lentille électromagnétique - (27) pour laisser passer les électrons dans une direction colinéaire à l'axe du tube.

4. Testeur de circuit intégré selon l'une quelconque des revendications 1 et 2, caractérisé en ce que les moyens de séparation (24) sont situés au-dessus de la lentille électromagnétique (27) pour focaliser les électrons primaires et comprennent trois pièces polaires ($24_1$ , $24_2$ et $24_3$) pour séparer le faisceau d'électrons primaires du faisceau d'électrons secondaires, diriger le faisceau d'électrons secondaires vers l'entrée du spectromètre (32) et rendre achromatique les moyens de séparation pour le faisceau d'électrons primaires dans une gamme d'énergie étendue comprise entre 500 eV et 10 KeV et rendre le faisceau d'électrons secondaires achromatique et stigmatique.

5. Testeur de circuit intégré selon l'une quelconque des revendications 1 à 3, caractérisé en ce que la lentille électromagnétique (27) pour focaliser les électrons primaires est constituée par un circuit magnétique (27) entourant le tube supportant l'anode (30) et comprend une entretoise amagnétique

annulaire (27₃) à proximité de l'anode (30) pour focaliser le faisceau d'électrons primaires sur les points du circuit intégré à tester.

6. Testeur de circuit intégré selon l'une quelconque des revendications 1 à 5, caractérisé en ce qu'il comprend un dispositif de balayage de faisceau (28, 29) disposé à l'intérieur de la lentille électromagnétique (27) pour positionner le faisceau d'électrons primaires sur les points du circuit intégré à tester et pour ramener le faisceau des électrons secondaires dans l'axe et dans la direction opposée d'arrivée des électrons du faisceau primaire.

7. Testeur de circuit intégré selon la revendication 6, caractérisé en ce que le dispositif de balayage comprend des électrodes de déviation (28) fixées sur la paroi interne du tube (39) supportant l'anode d'accélération (30) et des bobines de déflexion (29) disposées autour du tube support de l'anode d'accélération (30).

8. Testeur de circuit intégré selon l'une quelconque des revendications 1 à 7, caractérisé en ce que le spectromètre d'énergie est couplé aux moyens de séparation par l'intermédiaire d'une lentille électrostatique (31) et d'un quadrupôle (26).

FIG_1

FIG_2-A

FIG_2-B

FIG_3-A

FIG_3-B

FIG_3-C

FIG_4

FIG_5

FIG_6

FIG_7

FIG_8

# FIG_9-A

# FIG_9-B

FIG_10

FIG_11

# FIG_12-A

$24_2$

$24_1$

N | S

S | N

$24_3$

$24_4$

$24_5$

# FIG_12-B

a

a'

$24_4$

$24_5$

$24_6$

## DOCUMENTS CONSIDERES COMME PERTINENTS

| Catégorie | Citation du document avec indication. en cas de besoin. des parties pertinentes | Revendication concernee | CLASSEMENT DE LA DEMANDE (Int. Cl.4) |
|---|---|---|---|
| Y | FR-A-2 184 713 (MAX-PLANCK-GESELLSCHAFT ZUR FÖRDERUNG DER WISSENSCHAFTEN E.V.) * Figure 1; page 2, ligne 9 - page 3, ligne 3; page 4, ligne 11 - page 8, ligne 10 * | 1 | H 01 J 37/28 G 01 R 31/28 |
| | --- | | |
| Y | EP-A-0 138 610 (TEXAS INSTRUMENTS) * Figures 1,2; page 5, ligne 27 - page 10, ligne 13; page 13, ligne 7 - page 14, ligne 8 * | 1 | |
| A | | 2,3 | |
| | --- | | |
| A | GB-A-1 128 107 (HITACHI) * Figures 3,7; page 3, ligne 18 - page 4, ligne 28; page 4, ligne 75 - page 5, ligne 18 * | 1,5 | DOMAINES TECHNIQUES RECHERCHES (Int. Cl.4) H 01 J 37/00 G 01 R 31/00 |
| | --- | | |
| A | DE-A-2 116 289 (NIHON DENSHI) * Figures 3,4; page 7, dernier alinéa - page 10, fin du premier alinéa * | 1,4 | |
| | ----- | | |

Le présent rapport de recherche a été établi pour toutes les revendications

| Lieu de la recherche | Date d'achevement de la recherche | Examinateur |
|---|---|---|
| LA HAYE | 03-10-1986 | SCHAUB G.G. |